# EUROPÄISCHE PATENTSCHRIFT

(11) **EP 3 016 114 B1**
(45) Veröffentlichungstag und Bekanntmachung des Hinweises auf die Patenterteilung: **06.03.2019**
(21) Anmeldenummer: 15190059.4
(22) Anmeldetag: 15.10.2015
(51) Int. Cl.: H01C 1/082, H05K 7/20

(54) **GEKÜHLTE ELEKTRISCHER WIDERSTAND**
COOLED ELECTRICAL RESISTOR
RESISTANCE ELECTRIQUE REFROIDIE

(30) Priorität: 29.10.2014 DE 202014105179 U
(43) Veröffentlichungstag der Anmeldung: 04.05.2016
(73) Patentinhaber: REO Inductive Components AG, 16866 Kyritz (DE)
(72) Erfinder: REIMANN, Sven, 16866 Kyritz (DE)
(74) Vertreter: LS-MP von Puttkamer Berngruber Loth Spuhler

(56) Entgegenhaltungen:
- EP-A1- 2 709 115
- DE-A1- 4 421 025
- DE-A1- 19 545 447
- DE-U1-202012 009 701
- GB-A- 2 478 547
- US-A- 5 841 634

## Beschreibung

Die Erfindung betrifft einen elektrischen Widerstand mit einem, in einem Widerstandskörper angeordneten Widerstandselement und einer Kühlung, bei der Kühlflüssigkeit wenigstens einen Kühlkanal wenigstens eines Kühlkörpers durchströmt. Das Widerstandselement ist insbesondere als Platine, Stahlgitter oder Wickelgut ausgebildet. Diese Aufzählung ist jedoch in keiner Weise ausschließlich sondern nur beispielhaft gemeint. Im Weiteren wird das Widerstandselement vereinfachend als Platine bezeichnet
Aus der DE 10 2010 040 582 A1 ist ein Gehäuse für eine elektronische Schaltung mit integrierter Kühlmittelpassage bekannt. Das Gehäuse weist Bodenplatten und eine Deckplatten auf. Die Kühlmittelpassage ist als Hohlraum in der durch Spritzgießen oder durch andere Fertigungsmethoden, wie zum Beispiel Fräsen oder auch Fliesspressen, gefertigten Bodenplatte und/oder in der ebenfalls durch Spritzguss oder anderen Fertigungsmethoden hergestellten Deckplatte realisiert.

Die auf die Anmelderin zurückgehenden Druckschriften des deutschen Gebrauchsmusters DE 20 2012 009 701 U1 und der europäischen Patentanmeldung EP 2 709 115 A1 beschreiben einen elektrischen Widerstand mit einer in einem Widerstandskörper angeordneten Platine und einer Kühlung, bei der Kühlflüssigkeit wenigstens einen Kühlkanal wenigstens eines Kühlkörpers durchströmt; die Kühlkanäle zeigen einen unrunden Querschnitt sowie einen flächendeckenden Verlauf durch die Kühlkörper.

Wassergekühlte Widerstände, insbesondere Brems- und Belastungswiderstände gewinnen in der heutigen Kraftfahrzeug- sowie der Schienenfahrzeugindustrie immer größere Bedeutung. Wassergekühlte Widerstände können auch in anderen Industriezweigen Verwendung finden, wenn elektrische Motoren zum Antrieb von Haupt- und/oder Nebenaggregaten eingesetzt werden.

Bisher bekannte wassergekühlte Widerstände verfügen über eine vergleichsweise schlechte Wärmeverteilung und sind relativ aufwändig in der Herstellung. Es ist gängige Praxis, Kühlkanäle in Form von Rohrleitungen einzusetzen. Hierbei werden längs verlaufende Rohre mit quer verlaufenden Verbindungsrohren verschraubt, verklebt oder verlötet.

Diese Herstellungsart bedingt jedoch einen relativ hohen Fertigungsaufwand. Zusätzlich erweisen sich die Verbindungsstellen zwischen den längs- und/oder quer verlaufenden Rohrleitungen als Schwachstellen, da an diesen Stellen häufig Leckagen auftreten und Kühlflüssigkeit austritt.

Gelangt die Kühlflüssigkeit in der Folge mit dem elektrischen Widerstand in Kontakt, so kann dies zu einer erheblichen Beschädigung des elektrischen Widerstands führen.

Zur Ausgestaltung der Kühlkanäle werden häufig Aluminiumrohre mit einem runden Durchmesser verwendet. Diese Kühlkanäle sind jedoch nur bis zu einer bestimmten Leistungsdichte einsetzbar. Im Stand der Technik bekannte wassergekühlte Brems- und Belastungswiderstände weisen darüber hinaus den Nachteil auf, dass eine gleichmäßige Wärmeabfuhr aus dem Widerstandskörper nur schwer realisierbar ist. Andere Bereiche des Widerstandskörpers sind auf Grund ihrer räumlichen Anordnung oder ihrer Gestaltung nur schwer kühlbar. Die Temperaturwerte an der Oberfläche des Widerstandskörpers verbleiben daher vergleichsweise relativ hoch. Auf Grund der bisher eingesetzten Technik zeichnen sich die Brems- und Belastungswiderstände in der Regel durch ein vergleichsweise hohes Eigengewicht und durch relativ hohe Herstellungskosten aus.

Auf Grund stetig steigender Leistungsdichten moderner Elektromotoren stellt sich jedoch auch an Einrichtungen zur Wasserkühlung gekühlter Brems- und/oder Belastungswiderständen die Anforderung, immer höhere Temperaturen flächendeckend und möglichst zeitnah vom Widerstandskörper abführen zu müssen.

Ein Widerstand, der diesen Anforderungen gerecht wird, ist in der DE 10 2012 108 571 A1 offenbart. Diese Druckschrift zeigt bereits einen wassergekühlten Widerstand, insbesondere Brems- und/oder Belastungswiderstand, der ohne die vorgenannten Nachteile bekannter Widerstände funktioniert und zusätzlich bei einer gesteigerten Leistungsdichte optimierte Kühlwerte erbringt. Die Wärme wird weiterhin gesamtflächig vom Widerstandskörper abgeführt, so dass die Betriebstemperatur an der Oberfläche des Widerstands deutlich herabgesenkt werden kann.

Die dort gezeigte Erfindung offenbart eine Einrichtung zur Kühlung eines Widerstands, die verbesserte Kühlwerte aufweist bei gleichzeitig geringerem Gewicht und konstruktiv einfacherem Aufbau. Ferner stellt sie einen wassergekühlten Widerstand bereit, der anspruchsvollen Schutzartprüfungen bis zu IP 69 k genügt.

Dieser Art von elektrischen Widerständen werden häufig auftragsbezogen produziert. Die Nachfrage nach elektrischen Widerständen mit größerer Leistung steigt dabei ständig. Nachfragen nach Leistungen von 30 kW, 45 kW, 60 kW, 70 kW und darüber hinaus sind keine Seltenheit mehr. Jede Leistungssteigerung bedeutet aber prinzipiell die Notwendigkeit, die Flächen-Baugröße des Widerstands zu erhöhen, das heißt die Leistungssteigerung geht mit relativ großen Widerständen einher. Dies bedeutet weiterhin eine Erhöhung des Materialeinsatzes und der Kosten. Ferner erfordert dies eine Erhöhung der Anzahl der Werkzeuge, wenn für jede Größe des elektrischen Widerstands ein eigenes Bauteil angefertigt werden muss.

Der vorliegenden Aufgabe liegt somit die Aufgabe zugrunde, einen elektrischen Widerstand dahingehend weiterzubilden und zu verbessern, dass eine Vervielfachung der Leistung erreicht wird, ohne dass hierzu eine Vergrößerung der Flächenbaugröße des Widerstands notwendig ist und ohne dass für jede gewünschte Leistungsgröße ein spezifisches Werkzeug angefertigt werden müsste.

Gelöst wird diese Aufgabe mit den Merkmalen des Anspruches 1 durch eine modulare Bauweise bzw. eine Sandwichbauweise, wobei die wenigstens zwei Kühlkörper durch Anordnung wenigstens eines Zwischen-Kühlkörpers zwischen diesen modular übereinander oder nebeneinander angeordnet sind. Vorteilhafte Ausgestaltungen sind in den Unteransprüchen niedergelegt.

Durch die erfindungsgemäße Ausgestaltung ergibt sich die Möglichkeit mit weniger Konstruktions-/Entwicklungsaufwand mehrere Baugrößen und Leistungsgrößen zu realisieren.

Mehrere Baugrößen können mit wenigen, kleineren Gußformen realisiert werden.

Aufgrund der Erfindung ist es gelungen, die Kühlfläche jeder Leistungsgröße unabhängig von der Grundfläche zu erweitern durch modulare Mittelteile. Dies verschafft wesentliche Gewichts- und Preisvorteile gegenüber einer Neukonstruktion mit jeweils spezifischen Abmessungen der Grundfläche.

Die Vorteile der internen Verschaltung der elektrischen Komponenten und des Fluidsystems bleiben erhalten. Die urmechanische Festigkeit und der hohe Schutzgrad bei kleiner Bauform sind ebenfalls evidente Vorteile.

Weitere Vorteile ergeben sich aus der nachfolgenden Beschreibung.

Dabei hätte an sich nahe gelegen, allein die Flächen- Baugröße des Widerstands zu erhöhen, da mit dessen Aufbau ein internes Fluidverteilungssystem entsteht, bei dem nicht nur das Wasser intern verschaltet ist, sondern auch die Elektrik miteinbezogen ist. Die Vergrößerung der Flächen-Baugröße würde mithin an sich an diesem Aufbau des internen Fluidverteilungssystems prinzipiell nichts ändern.

Die Erfindung bezieht sich insbesondere auf einen Flachwiderstand.

Der Aufbau und die Funktionsweise des erfindungsgemäßen Widerstands sollen im Folgenden anhand eines wassergekühlten Brems- und/oder Belastungswiderstands dargestellt werden. Der Widerstand umfasst dabei ein Widerstandselement z.B. eine Platine, an deren Oberflächen zu beiden Seiten je ein Kühlkörper angeordnet ist.

Dabei bezieht sich die nachfolgende Darstellung zunächst auf den Aufbau und die Funktionsweise eines elektrischen Widerstands, wie er der vorliegenden Weiterentwicklung im Prinzip zugrunde liegt.

Der Kühlkörper umfasst eine Kühlplatte, die im verbauten Zustand mit einem Deckel verschlossen ist. Die Kühlplatte umfasst ihrerseits einen Rücken sowie an den Kanten des Rückens umlaufende Seitenwände. Zwischen der Platine und den an der Platine anliegenden Rücken der Kühlkörper ist jeweils eine Sand- und/oder Glimmerschicht aufgetragen, welche auch mit anderen hitzebeständigen Isoliermaterialien realisiert werden können

Zur Abdichtung der Platine gegenüber dem Rücken der Kühlplatte des Kühlkörpers ist ein umlaufender Dichtungskörper vorgesehen. Weiter ist es denkbar, die Platine zur Abdichtung gegenüber dem Rücken der Kühlplatte mit diesem zu verkleben.

Eine Wasserkühlung führt den zu kühlenden Oberflächen zum Beispiel mithilfe von Kühlkanälen Kühlflüssigkeit zu. Die Kühlkanäle dienen dabei als Wärmetauscher, die die Oberflächentemperatur aufnehmen und von den zu kühlenden Oberflächen des Widerstandskörpers wegführen. Ein bedeutender Vorteil der Wasserkühlung gegenüber der Luftkühlung besteht z.B. in dem höheren Wärmeübergangskoeffizienten der Wasserkühlung gegenüber der Luftkühlung. Der Wasserübergangskoeffizient zwischen Luft und einem Festkörper ist um etwa dem Faktor 50 bis 100 niedriger, als der Wärmeübergangskoeffizient zwischen Wasser und einem Festkörper. Überdies erfordert die Luftkühlung eine wesentlich größere Kontaktfläche zwischen der zu kühlenden Oberfläche und dem Kühlungsmedium Luft. Weiterhin erfordert eine Luftkühlung im Vergleich zur Wasserkühlung wesentlich höhere Strömungsgeschwindigkeiten, die - technisch aufwendig - durch ein Kühlgebläse bereitgestellt werden müssen.

Statt Wassers kann auch eine andere Kühlflüssigkeit oder eine Mischung hieraus verwendet werden.

Als Widerstand wird insbesondere ein zweipoliges, passives elektrisches Bauteil verstanden, das der Realisierung eines ohmschen Widerstands in elektrischen und elektronischen Schaltungen dient. Der Widerstand begrenzt den elektrischen Strom, teilt die elektrische Spannung in einer Schaltung auf und wandelt zusätzlich elektrische Energie in Wärmeenergie um.

Bremswiderstände dienen bei elektrischen Maschinen in der Regel gleichzeitig als Anfahrwiderstände, mit dem Zweck, zum Schutz eines elektrischen Fahrmotors während des Anfahrens zugeschaltet zu werden, um den Strom im Elektromotor auf ein erforderliches Maß zu begrenzen. Sobald der Elektromotor als elektromotorische Bremse arbeitet, schützt der Bremswiderstand den Elektromotor vor überhöhter Spannung durch Induktion. Gleichzeitig bewirkt der Strom eine Drehzahlverringerung des Elektromotors und erzielt damit eine Bremsung des Fahrzeugs.

Ein Belastungswiderstand liegt im DC-Stromkreis eines elektrischen Geräts oder eines elektrischen Bauteils und belastet das Quellgerät, welches an dem Eingang des Bauteils die Spannung liefert. In diesem Zusammenhang bezeichnet man die maximale Belastbarkeit des Widerstands als Nennlast.

In ein gegossenes Werkstück werden Kühlkanäle eingebracht. Das Gusswerkstück kann aus einer Eisen-Kohlenstoff-Verbindung (Gusseisen oder Stahl) hergestellt sein. In gleicher Weise ist es möglich, nicht Eisenmetalle wie beispielsweise Kupfer, Blei, Zinn, Zink, Nickel in Reinform oder als Legierungen zu verwenden. Das Gusswerkstück kann jedoch auch in Leichtmetallform wie z.B. aus Aluminium, Magnesium oder Titan oder aus einer Legierung derselben hergestellt sein. Des Weiteren ist es denkbar, dass das Gusswerkstück aus anderen gießbaren Materialien, wie z.B. aus Kunststoff, hergestellt ist. Die vorausgehend genannten Werkstoffe sind jedoch in keiner Weise ausschließlich, sondern nur beispielhaft gemeint. Weiterhin ist es denkbar, dass das Gusswerkstück ein Strangguss-Werkstück ist, in das die Kühlkanäle eingefräst sind.

Der Kühlkörper, insbesondere das mit Kühlkanälen versehene Werkstück ist ganz oder teilweise als Keramikbauteil ausgebildet. Andere Werkstoffe sind ebenfalls möglich.

Jeder Kühlkörper umfasst eine Kühlplatte, deren Rücken mit umlaufenden Seitenwänden als Gusswerkstück ausgebildet ist. Der Deckel, der die Kühlplatte abschließt, kann ebenfalls als Gussstück gearbeitet sein. An der Innenseite des Rückens der Kühlplatte, die dem Deckel zugewandt ist, sind in das Gusswerkstück Kühlkanäle eingearbeitet.

Die Kühlkanäle können z.B. durch Fräsen in das Gusswerkstück eingebracht sein. Außer durch Fräsen können die Kühlkanäle jedoch auch mit anderen technischen Möglichkeiten in das Gusswerkstück eingebracht sein. Da in einem Widerstandskörper wenigstens zwei Kühlplatten eingesetzt werden, kann der Montageaufwand erheblich reduziert werden.

Die Kühlkanäle können in Reihe geschaltet sein. Zusätzlich ist es möglich, dass die Kühlkanäle parallel geschaltet werden.

Besonders bevorzugt verlaufen die Kühlkanäle mäandernd im Gusswerkstück, wobei sich die Kühlkanäle ausgehend von einer Kühlmittelzulaufbohrung zu einer Kühlmittelablaufbohrung erstrecken.

Die Kühlmittelzuführung an der Kühlmittelzulaufbohrung und an der Kühlmittelablaufbohrung erfolgt vorzugsweise mittels eines Gewindes oder einer Schlauchtülle erfolgt, die am Gehäuse des Widerstandskörpers befestigt sind.

Die Kühlkanäle weisen Streckenabschnitte auf, die achsparallel zu einander verlaufen und durch umleitende Verbindungsstücke miteinander kommunizieren.

Weiter können die Kühlkanäle versetzt zu einander und in Reihe angeordnet sein und über ein Verbindungsstück aneinander gekoppelt werden.

Die Verbindungsstücke ermöglichen einen möglichst gleichförmigen und ungehinderten richtungsändernden Übergang von einem Streckenabschnitt des Kühlkanals zum benachbarten nächsten Streckenabschnitt. Gleichzeitig wird eine Optimierung der Strömungsgeschwindigkeit des Kühlmittels innerhalb der Kühlkanäle erreicht.

Die Kühlkanäle können ein rundes Profil, ein ovales Profil, ein mehreckiges Profil oder jede andere zweckdienliche Profilformung aufweisen.

Die Kühlkanäle weisen vorzugsweise zur Vergrößerung ihres Durchmessers und ihrer Oberfläche einen unrunden Verlauf auf. Zusätzlich ist es denkbar, einen eckig-abgewinkelten Verlauf der Kühlkanäle vorzusehen.

Zur Vergrößerung des Querschnitts des Kühlkanals ist in einer flachen Kanalausführung die Breite des Kühlkanals größer als die Höhe des Kühlkanals. Darüber hinaus kann ebenfalls zur Vergrößerung des Querschnitts des Kühlkanals die Höhe des Kühlkanals seine Breite überragen.

Eine bevorzugte Ausführungsform sieht weiter vor, dass die Kühlkanäle lamellenartige Rippen aufweisen, die in den Querschnitt der Kühlkanäle hineinragen. Darüber hinaus ist es möglich, zur Oberflächenvergrößerung Finnen oder sonstige Strömungsleitbleche im Kühlkanal vorzusehen. An den jeweiligen Enden ihrer Länge gehen sie bevorzugt in gebogener Form in ihre Gegenrichtung über. Zusätzlich können die Kühlkanäle bevorzugt einen wellenförmigen Boden aufweisen. Zur Vergrößerung der Oberflächen der Kühlkanäle können die Kühlkanäle eine Wellenstruktur aufweisen. Die Wellen in Boden und Wandung der Kühlkanäle bewirken eine Verwirbelung innerhalb der Kühlflüssigkeit, die die Wärmeabfuhr zusätzlich begünstigt. Eine Verwirbelung innerhalb der Kühlflüssigkeit kann auch durch einen eckigen Verlauf des Kühlkanals hervorgerufen werden.

Zum Verschließen der Kühlplatte des Kühlkörpers ist der Deckel vorgesehen, der mit der zugehörigen Kühlplatte verschweißt oder verklebt wird. Die vorgenannten Verbindungsformen sind nur rein exemplarisch und in keiner Weise ausschließlich gemeint.

Im verbauten Zustand weist der wassergekühlte Brems- und/oder Belastungswiderstand wenigstens zwei Übergänge auf, die jeweils in etwa rechtwinklig zu den Kühlmittelkanälen verlaufen und eine Strömungsverbindung zwischen dem Kühlkörper der einen Seite der Platine zum Kühlkörper auf der anderen Seite der Platine ermöglichen.

Kühlmittel strömt durch die Kühlmittelzulaufbohrung in das Innere der einen Kühlplatte ein. Durch die Kühlkanäle des einen Kühlkörpers fließt das Kühlmittel zu einem Übergang in den Kühlkörper auf der anderen Seite der Platine. Aus dem letztgenannten Kühlkörper wird das Kühlmittel durch eine Kühlmittelablaufbohrung, einem Kühlmittelreservat zugeführt.

Die Kühlkanäle können in Mäander-Form, in Schlangenlinien, spiralförmig oder in Form einer Ellipse oder in einer anderen geometrischen Form verlaufen. Zum Zweck der möglichst flächendeckenden Kühlung der Platine können die Kühlkanäle auch in anderer Form in der Kühlplatte angeordnet und in anderer Weise in die Kühlplatte eingebracht werden.

Ein Übergang zwischen den jeweiligen Kühlkörpern gewährleistet, dass die Kühlflüssigkeit beide Seiten der Platine kühlt. In gleicher Weise wird gewährleistet, dass auf beiden Seiten der Platine flächendeckend und lokal an sogenannten Hot-Spots Wärme aus dem Widerstandskörper abgeführt werden kann.

In einer Variante der Ausgestaltung des Widerstands umfasst der Kühlkörper einen Werkstoff besonders hoher Wärmeleitfähigkeit. Eine Verbesserung der Wärmeleitung bei gegossenen Kühlkörpern ist z.B. durch Einsatz von Eisenoxiden wie z.B. Aluminiumoxid oder zusätzlich durch Verguss mittels Hochtemperaturmassen möglich.

Das Widerstandsgehäuse, das die beiden miteinander verbundenen Kühlkörper und die zwischen den Kühlkörpern angeordnete Platine umfasst, erfordert keine zusätzlichen funktionellen Anbauten außerhalb des Widerstandsgehäuses.

Zur Stromversorgung können z.B. an der Stirnseite des Widerstandskörpers Steckbuchsen und/oder Steckverbindungen angeordnet sein, die in eine Anschlusskammer einmünden, die die Bauteile und Anschlüsse umfasst, die der Anbindung des Widerstands an den Stromkreislauf dienen.

Bei dem beschriebenen Widerstand werden wenigstens drei Dichtungskörper eingesetzt, wobei ein erster Dichtungskörper die umlaufende Dichtung ist, die die Platine gegenüber den an der Platine anliegenden Kühlkörpern abdichtet. Die wenigstens zwei weiteren Dichtungskörper sind im Bereich des Kühlmittelzulaufs und des Kühlmittelablaufs angeordnet und dienen der Abdichtung der Platine gegenüber der Kühlmittelflüssigkeit, die den Kühlmittelzulauf und/oder den Kühlmittelablauf durchströmt.

Anstelle der Dichtkörper können auch andere funktionsdienliche Dichtungseinrichtungen oder auch flüssige Dichtmassen Verwendung finden.

Ein Widerstand dieser Art erfüllt die Anforderungen hoher Schutzarten wie z.B. IP 69 k.

Es ist eine umlaufende Seitenwand vorgesehen, die sich entlang der Außenkanten der Kühlplatte erstreckt. Die umlaufende Seitenwand erhebt sich auf der von der Platine abgewandten Seite der Kühlplatte in etwa rechtwinklig zur Kühlplatte und trägt im verbauten Zustand den Deckel, der den Kühlkörper nach außen abschließt. Mit der vom Deckel abgewandten Seite des Rückens der Kühlplatte liegt der Kühlkörper an einer Seitenwand der Platine an. Zwischen der Seitenwand der Platine und dem Rücken der Kühlplatte erstreckt sich dabei eine Schicht aus Glimmer und/oder Sand. An jeder Seitenwand der Platine kann wenigstens eine Kühlplatte angeordnet sein.

Damit Kondenswasser, das sich im Bereich der Platine bildet, aus dem Widerstandsgehäuse heraus diffundieren kann, ist am Widerstandsgehäuse vorzugsweise eine Membran vorgesehen. Die Membran kann in eine Richtung oder in beiden Richtungen durchlässig sein. Es ist vorstellbar, an mehr als einer Stelle am Widerstandsgehäuse eine Membran anzuordnen. Die Membran kann aus wenigstens einem Material gefertigt sein, das ein Diffundieren von Kondenswasser aus dem Widerstandsgehäuse nach außen begünstigt.

Der Kühlkörper umfasst eine Anschlusskammer, in der Einrichtungen angeordnet sein können, die der Stromversorgung des Widerstandskörpers und/oder der Platine dienen.

Der Kühlkörper umfasst weiter eine Platinenkammer, in die die Platine aufgenommen ist. Die Kühlkörper des Widerstandskörpers umfassen mindestens je eine Anschlusskammer und mindestens je eine Platinenkammer, wobei die Kühlkörper so ausgebildet sind, dass im zusammengebauten Zustand die Anschlusskammern bzw. die Platinenkammern der jeweiligen Kühlkörper einander gegenüber liegen.

Zur Optimierung der Wärmeübertragung vom Kühlkörper auf das Kühlmittel kann die Oberflächeneigenschaft der Kühlkanäle durch eine Oberflächenbehandlung optimiert werden.

Zur Beschichtung der Oberflächen der Kühlkanäle kann Nanotechnologie eingesetzt werden. Nanokörper verhalten sich dabei nicht mehr wie amorphe Substanzen, sondern nehmen vielmehr die Eigenschaften des Kühlmittels (z.B. Kühlflüssigkeit) an.

Vorzugsweise sind die Kühlkanäle in die Oberfläche eines Werkstücks eingearbeitet sind und durch einen Deckel abgedeckt.

Eine Vergrößerung des Durchmessers der Kühlkanäle im Gusswerkstück führt zu einer Erhöhung des Durchsatzes an Kühlmittel im Kühlkanal. Eine daraus folgende erhöhte Wärmeaufnahmekapazität führt weiter zu einer flächendeckenden Verbesserung der Kühlung im Widerstandskörper.

Rechteckförmige oder mehreckförmige Kühlkanäle, die in das Gusswerkstück des Kühlkörpers eingefräst sind, erhöhen die Wärmeaufnahmekapazität des Kühlmittels gegenüber dem Einsatz von Kühlrohren aus Aluminium, die bisher als Kühlkanäle eingesetzt wurden.

Die Einbringung von Kühlkanälen in das Gusswerkstück des Widerstandskörpers reduziert die Gefahr, dass sich insbesondere an Verbindungsstellen zwischen zwei Kühlrohren Leckagen bilden. Die Kühlmittelpassage ist als Hohlraum in der durch Spritzgießen oder durch andere Fertigungsmethoden, wie zum Beispiel Fräsen oder auch Fliespressen gefertigten Bodenplatte und/oder in der ebenfalls durch Spritzguss oder anderen Fertigungsmethoden hergestellten Deckplatte realisiert. Eine Undichtigkeit innerhalb des Kühlkanals führt zu einem fortschreitenden Verlust an Kühlmittel und weiter zu Druckverlust innerhalb des Kühlkanals. Ein Druckabfall im Kühlkanal führt weiter zu einer Verringerung der Kühlung innerhalb des Widerstandskörpers, wodurch eine Beschädigung des Widerstands erfolgen kann.

Die Fertigstellung und der Einbau des Widerstandskörpers erfordern nur noch ein Minimum an Blindschrauben und vergleichsweise wenige Anschlüsse.

Die Platine des Widerstandskörpers kann zur elektrischen Isolation gegen den Kühlkörper in einer Schicht aus Glimmer und/oder Sand eingebettet sein. Hierdurch wird eine kompakte Bauweise und eine einfache Fertigung begünstigt.

Eine elektrische Isolation kann darüber hinaus durch Verwendung eines besonderen Plattenmaterials und/oder durch Verguss erfolgen. Der Widerstand ist als Wickelgut, und/oder als Plattenwiderstand ausgebildet, wobei der Plattenwiderstand Widerstandsmaterialien umfasst.

Für die kompletten Leistungen wirkt oben und unten die Kühlfläche des Kühlkörpers.

Soll die Leistung des Widerstandes vergrößert, etwa verdoppelt werden, so sieht die vorliegende Erfindung einen modularen Aufbau bzw. einen Sandwichaufbau des elektrischen Widerstandes vor.

Zu diesem Zweck wird ein Zwischen-Kühlkörper eingesetzt werden, wodurch es ermöglicht wird, die gleiche Grundfläche des basis-elektrischen Widerstands beizubehalten, der aus einem Ober- und Unterteil besteht. Wird erfindungsgemäß ein Zwischen-Kühlkörper zwischen dem Ober- und Unterteil vorgesehen, entstehen hierdurch zwei Kammern zwischen dem Unterteil und dem Mittelteil und zwischen dem Mittelteil und dem Oberteil.

Gemäß dieser Sandwichbauweise verbleibt es bei der Ausgestaltung dergestalt, dass der Widerstand zwar oben und unten auch nur einmal über die erforderliche Kühlfläche verfügt, aber die Zwischen-Kühlkörper kühlen auf beiden Seiten.

Betrachtet man mithin die reine Oberfläche, wird im Vergleich zu dem oben geschilderten Grundaufbau des Widerstands gleich gekühlt, aber das Bauvolumen wird dadurch kleiner.

Die Zwischen-Kühlkörper sind dabei wie bei dem oben dargestellten Grundaufbau parallel geschaltet, das heißt es gibt eine Verrohrung dazwischen, die genauso gestaltet ist wie bei dem Grundaufbau, also prinzipiell mit denselben Arten von Dichtringen, Übergängen etc.

Durch die Einbeziehung eines Zwischen-Kühlkörpers kann der elektrische Widerstand jedoch in zwei Richtungen gekühlt werden, nämlich nach oben und nach unten, was nach dem vorbeschriebenen Grundaufbau des Widerstandes nicht möglich wäre.

Soll etwa die Leistung des ersten Widerstandes von 15 kW auf 30 kW erörtert werden, so besteht der erste Widerstand aus einem Ober- und Unterteil mit Kühlfunktion. Bei der Verdoppelung des gewünschten Leistungsspektrums wird ein Zwischen-Kühlkörper dazwischen gesetzt, durch den zwei Kammern entstehen, nämlich zwischen dem Unterteil und dem Mittelteil einerseits und zwischen dem Mittelteil und dem Oberteil andererseits.

Strebt man an, in diesem Beispielsfall die Leistung des Widerstands von 15 kW auf 45 kW zu erhöhen, so werden dann entsprechend zwei weitere Zwischen-Kühlkörper verwendet. Die Anzahl der Kammern erhöht sich entsprechend.

Auf diese Weise können auch weitere Zwischen-Kühlkörper je nach gewünschter Leistungssteigerung eingesetzt werden.

Bei der erfindungsgemäßen Ausgestaltung ist es also möglich, die Grundfläche des Widerstands beizubehalten; der Widerstand unterscheidet sich je nach Anzahl der eingesetzten Zwischen Kühlkörper der Höhe nach. Dadurch, dass die mittleren Platten nach oben und unten mitkühlen, wird die erforderliche Kühlfläche zur Verfügung gestellt; aber die Grundfläche des Widerstands muss nicht vergrößert werden.

Dadurch ist auch weniger Materialeinsatz notwendig. Auch das Gewicht des Gesamt-Widerstandes steigt im Verhältnis zur Vergrößerung der Leistung nicht proportional.

Dadurch reduzieren sich die Materialkosten. Dieser Kostenvorteil ermöglicht es im Besonderen, auf Fräs-Vorgänge weitgehend oder vollständig zu verzichten. Stattdessen kann ein an sich teurerer Aluminium-Guss eingesetzt werden. Dadurch erhöhen sich an sich zwar die Werkzeugkosten. Bei einem erfindungsgemäßen modularen Aufbau benötigt man aber etwa nur drei Werkzeuge, um vier verschiedene Leistungen umzusetzen. Nach der herkömmlichen Herangehensweise bräuchte man für einen Widerstand zwei Werkzeuge, mit der Folge, dass etwa für vier Baugrößen/Leistungskategorien dann acht Werkzeuge notwendig wären.

Es hat sich überraschend gezeigt, dass die modulare Einbettung eines oder mehrerer Zwischen-Kühlkörper in dem vorbeschriebenen Grundaufbau eine genauso effektive Kühlleistung mit sich bringt, wie dies bei einem elektrischen Widerstand der Fall wäre, bei dem die Leistungserhöhung mit einer entsprechenden Vergrößerung der Grundfläche der Baugrößer einher ginge.

In diesem vorgeschilderten Ausführungsbeispiel sind die modular angeordneten Kühlkörper übereinander liegend. Selbstverständlich lässt sich diese platzsparende Anordnung auch dadurch verwirklichen, dass die modular eingesetzten Kühlkörper nebeneinander, etwa senkrecht zur Grundfläche angeordnet sind.

Auch eine etwa schräg verlaufende Sandwichbauweise ist möglich.

Die Kühlkörper können dabei teilweise oder vollständig kontaktbildend aneinander liegen oder einen definierten Abstand zueinander aufweisen.

Die Erfindung wird nachfolgend anhand von Ausführungsbeispielen mit Hilfe von Figuren näher erläutert.
- Fig. 1:: zeigt einen Widerstandskörper nach dem herkömmlichen Stand der Technik,
- Fig. 2.:: zeigt eine Wärmeverteilung eines nach dem herkömmlichen Stand der Technik gekühltem Widerstands,
- Fig. 3-6:: zeigen den der Erfindung zugrunde liegenden Grundaufbau eines Kühlsystems für den Widerstand, wobei

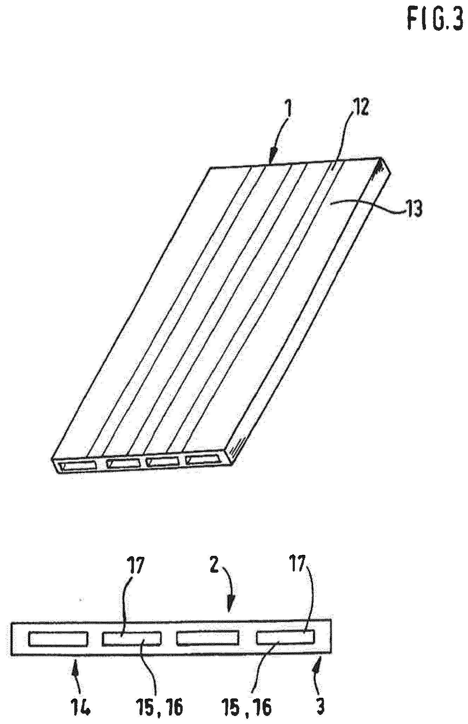

- Fig. 3:: eine Wärmeverteilung mit einem wassergekühlten Widerstand zeigt,

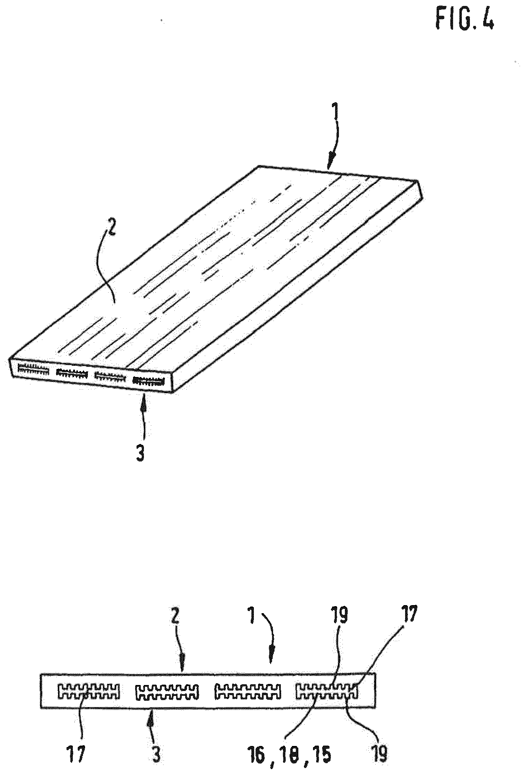

- Fig. 4:: ebenfalls die Wärmeverteilung eines wassergekühlten Widerstandskörpers zeigt,

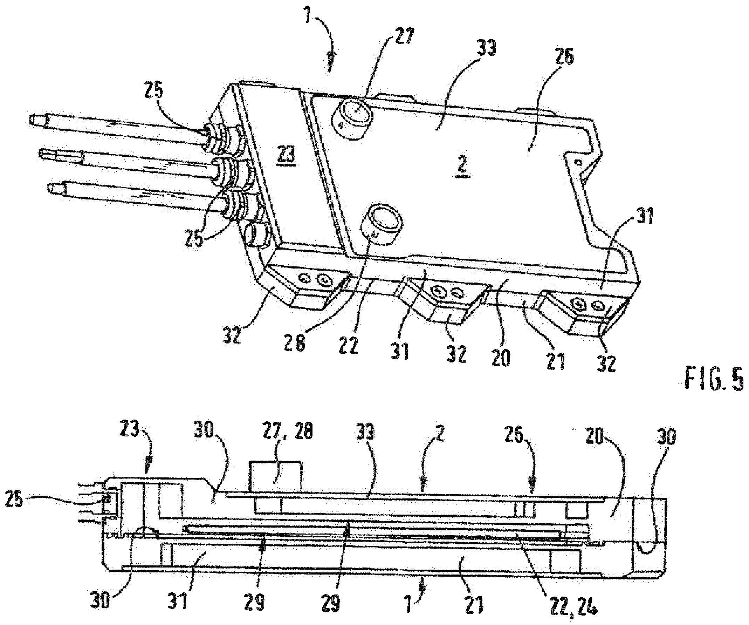

- Fig. 5:: den Widerstand in perspektivischer Darstellung zeigt und

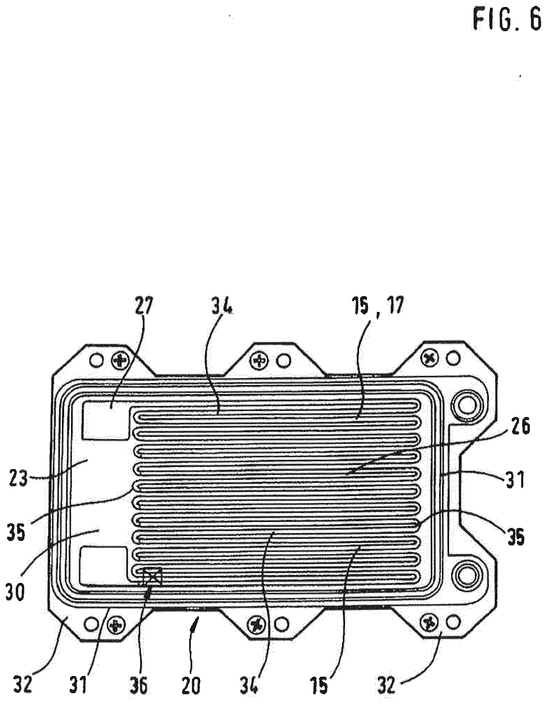

- Fig. 6:: einen Kühlkörper mit Kühlkanälen zeigt,

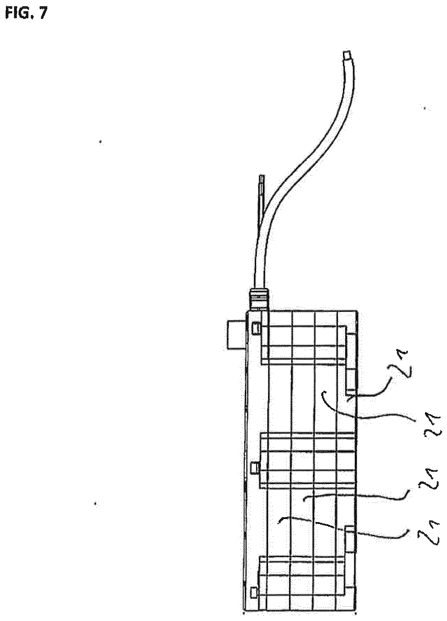

- Fig. 7:: zeigt den modularen Aufbau des erfindungsgemäßen Widerstands.

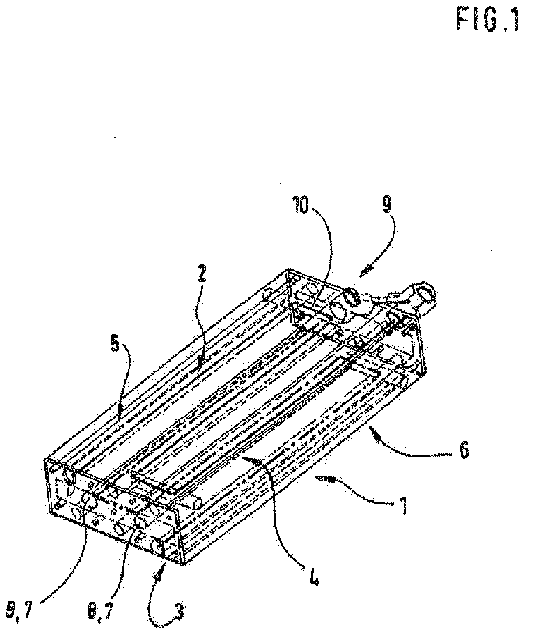

Fig. 1 zeigt einen Widerstandskörper 1 aus dem herkömmlichen Stand der Technik mit oberen 2 und unteren 3 Seitenwänden, die über eine seitliche Wand mit einander verbunden sind. Der Widerstandskörper 1 ist in perspektivischer Darstellung gezeigt und weist voneinander beabstandete Kühlkörper 5; 6 auf, in denen sich achsparallel zueinander verlaufende Kühlkanäle 7 erstrecken. Die Kühlkanäle 7 sind als Aluminiumrohre dargestellt, die jeweils einen runden Querschnitt 8 aufweisen. Im Bereich der Stirnseiten 9 sind die Kühlkanäle 7 durch nicht dargestellte, quer verlaufende Kühlkanäle 10 mit einander verbunden. Die querverlaufenden Kühlkanäle 10 sind mit den entlang der Längsachse des Widerstandskörpers verlaufenden Kühlkanälen 7 verschweißt, verklebt oder in einer anderen Weise befestigt.

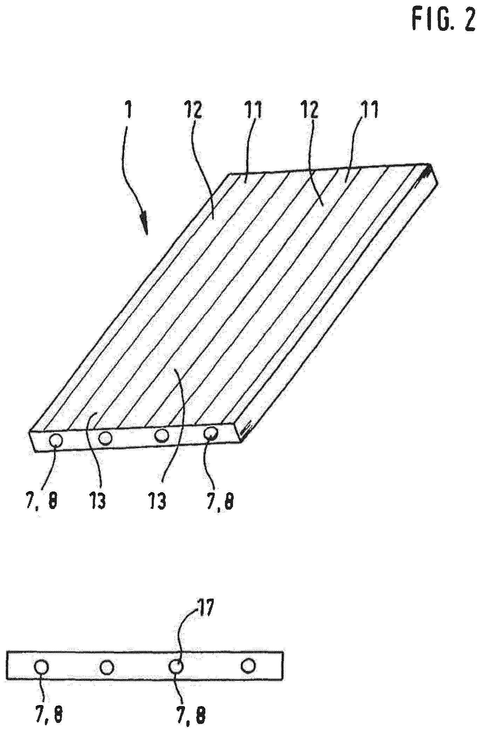

Fig. 2 zeigt die Wärmeverteilung eines herkömmlich gekühlten Widerstandskörpers 1. In den Widerstandskörper 1 sind Kühlkanäle 7 eingebettet, die einen runden Querschnitt 8 aufweisen und in etwa achsparallel zur Längsachse des Widerstandskörpers 1 verlaufen. In den Bereichen, in denen die Kühlkanäle 7 in den Widerstandskörper 1 eingebettet sind, liegen die Bereiche 11 niedriger Temperatur. Die Bereiche gehen zu beiden Seiten in Bereiche 12 über, die erhöhte Temperaturwerte ausweisen. Zwischen den Bereichen 11 des Widerstandskörpers 1, die durch die Kühlkanäle 7 auf niedrige Temperaturwerte herabgekühlt sind verlaufen Bereiche 13, in denen der Widerstandskörper 1 nahezu ungekühlt ist.

Aus Fig. 2 ist ersichtlich, dass die Kühlung des Widerstandskörpers 1 nach dem hier gezeigten Stand der Technik weite Bereiche 11 des Widerstandskörpers 1 nahezu ungekühlt lässt. Benachbarte Bereiche 12 weisen dagegen sehr niedrige Temperaturwerte auf. Die hohen Temperaturdifferenzen innerhalb des Widerstandskörpers 1 aus dem Stand der Technik können zur Beschädigung des Widerstandskörpers 1 oder seiner Bestandteile führen.

In Fig. 3 ist eine Temperaturverteilung eines Widerstandskörpers 1 gezeigt, der mit Hilfe der erfindungsgemäßen Kühlkörper 14 abgekühlt wird. Die in Fig. 3 verwendeten Kühlkanäle 15 weisen einen rechteckigen Querschnitt 16 auf, der im Vergleich zum runden Querschnitt 8 des Kühlkanals 7 aus Fig. 2 einen wesentlich höheren Durchsatz an Kühlflüssigkeit 17 ermöglicht. In Fig. 3 sind die Temperaturunterschiede innerhalb des Widerstandskörpers 1 wesentlich geringer, da im Bereich der oberen/unteren Seitenwand 2; drei nur noch Bereiche 12 mittlere Temperaturwerte und Bereiche 13 hohe Temperaturwerte erkennbar sind.

Die Gefahr, dass der Widerstandskörper 1 durch hohe Temperaturdifferenzen zwischen Bereichen 11 niedriger Temperatur und Bereichen 13 hoher Temperatur beschädigt wird, kann auf diese Weise wirksam verhindert werden. Aus den Figuren 2 und 3 ist zu erkennen, dass die gleichmäßigere Temperaturverteilung innerhalb des Widerstandskörpers 1 auf den geänderten Querschnitt des Kühlkanals 7; 15 zurückzuführen ist. In Fig. 2 erfolgt die Kühlung des Widerstandskörpers über vier Kühlkanäle 7 mit rundem Querschnitt 8, wogegen zur Kühlung des Widerstandskörpers 1 erfindungsgemäß in Fig. 3 Kühlkanäle 15 mit rechteckigem Querschnitt 16 verwendet werden.

Fig. 4 zeigt die Wärmeverteilung auf der oberen bzw. unteren Seitenwand 2; 3 des Widerstandskörpers 1. In Fig. 4 wird die Oberfläche 18 des rechteckigen Querschnitts 16 des Kühlkanals 15 durch Einbringung zusätzlicher Lamellen 19 vergrößert. Die Wärmeübertragung vom Widerstandskörper 1 auf das Kühlmittel 17 kann auf diese Weise erheblich gesteigert werden.

Fig. 5 zeigt in perspektivischer Darstellung den Widerstandskörper 1 mit einem oberen Kühlkörper 20 sowie einem unteren Kühlkörper 21. Zwischen den beiden Kühlkörpern 20; 21 ist eine Platine 22 des Widerstands 24 dargestellt. An der oberen Seitenwand 2 des Widerstandskörpers 1 ist eine Anschlusskammer 23 gezeigt, die die elektrischen Einrichtungen des Widerstands 24 umfasst.

An der Stirnseite des Widerstandskörpers 1 sind Steckbuchsen bzw. Steckverbindungen 25 dargestellt. Ebenfalls an der oberen Seitenwand 2, benachbart zur Anschlusskammer 23 ist die Platinenkammer 26 erkennbar, in deren Bereich die Platine 22 des Widerstands 24 angeordnet ist. Auf der Oberseite 2 der Platinenkammer 26 ragen je eine Kühlmittelzulaufbohrung 27 und eine Kühlmittelablaufbohrung 28 aus der Platinenkammer 26 heraus. Im verbauten Zustand des Widerstandskörpers 1 erfolgt die Zuleitung des Kühlmittels 17 durch die Kühlmittelzulaufbohrung 27. Nach Durchströmung der Kühlkanäle 15 wird das Kühlmittel 17 durch die Kühlmittelablaufbohrung 28 einem nicht dargestellten Kühlmittelreservoir zugeführt.

Der Widerstandskörper 1 umfasst die Platine 22 (nicht dargestellt), die wenigstens je eine obere und eine untere Seitenfläche aufweist. An wenigstens einer Seitenfläche der Platine 22 liegt wenigstens ein Kühlkörper an. Zwischen der Seitenfläche der Platine und dem Kühlkörper ist eine Schicht 29 aus Sand bzw. Glimmer angeordnet, die zur elektrischen Isolation der Platine 22 vorgesehen ist. Der Kühlkörper 20; 21 umfasst einen Rücken 30 sowie umlaufende Seitenwände 31.

Die Nasen und Verbindungselemente 32, die am Kühlkörper 20; 21 angeordnet sind dienen der Verbindung der einander gegenüberliegenden Kühlkörper 20; 21 mit einander. Gleichzeitig dienen sie der Befestigung des Widerstandskörpers 1 an einer nicht gezeigten Basis z.B. eines Elektromotors.

Fig. 6 zeigt in Draufsicht den Kühlkörper 20; 21 ohne Deckel 23 (Fig. 5), mit Blick auf die Kühlkanäle 15. Am Außenumfang des Kühlkörpers 20; 21 ist die umlaufende Seitenwand 31 des Kühlkörpers 20; 21 erkennbar. Im verbauten Zustand liegt der Deckel 33 (nicht dargestellt) auf der umlaufenden Seitenwand 31 auf und schließt den Kühlkörper 20; 21 dichtend ab. Auf seiner von der Platine 22 abgewandten Seite sind in den Rücken 30 des Kühlkörpers 20; 21 Kühlkanäle 15 eingearbeitet. In Fig. 6 verlaufen die Kühlkanäle 15 in etwa achsparallel zueinander, wobei die Umlenkung des Verlaufs der geradlinigen Streckenabschnitte 34 der Kühlkanäle 15 durch Verbindungsstücke 35 bewirkt wird. Die mäanderförmige Anordnung der Kühlkanäle 15 ermöglicht eine flächendeckende Kühlung der anliegenden Platine 22 des Widerstandskörpers 1. Die Kühlkanäle 15 erstrecken sich im Bereich der Platinenkammer 26, wobei die elektrischen Anschlüsse 25 der Platine 22 im Bereich der Anschlusskammer 23 des Widerstandskörpers 21 angeordnet sind.

Mit Bezugsziffer 27 ist die Kühlmittelzulaufbohrung dargestellt, über die das Kühlmittel 17 in die Kühlkanäle 15 eingespeist wird. Nach Durchströmung der Kühlkanäle 15 im Kühlkörper 20; 21 gelangt das Kühlmittel 17 durch einen Übergang 36 in den Kühlkörper 21, der auf der gegenüberliegenden Seite der Platine 22 angeordnet ist. Nach Durchströmung der Kühlkanäle 15 des gegenüberliegenden Kühlkörpers 21 wird das Kühlmittel 17 durch die Kühlmittelablaufbohrung einem nicht dargestellten Kühlmittelreservoir zugeführt.

Die Platine 22 wird durch einen umlaufenden Dichtungskörper (Fig. D) gegenüber dem Kühlkörper 20; 21 abgedichtet. Weitere Dichtungskörper 37 sind im Bereich der Kühlmittelzulaufbohrung 27 bzw. der Kühlmittelablaufbohrung 28 angeordnet.

In Draufsicht auf den Kühlkörper 20; 21 sind die Nasen bzw. die Verbindungselemente 32 dargestellt, mit denen die beiden Kühlkörper 20; 21 aneinander befestigt werden können bzw. mit denen der Widerstandskörper 1 an einer nicht gezeigten Basis z.B. angeschraubt werden kann.

Fig. 7 zeigt den Sandwichaufbau des erfindungsgemäßen Widerstands, wobei in diesem Ausführungsbeispiel drei zusätzliche Kühlkörper 21 zu erkennen sind, so dass der Widerstand bei einer angenommenen Grundleistung von 15 kW eine Leistung von 60 kW ermöglicht. Die Kühlkörper 21 sind dabei erfindungsgemäß übereinander angeordnet.

### Bezugszeichenliste

- 1: Widerstandskörper
- 2: obere Seitenwand
- 3: untere Seitenwand
- 4: seitliche Wand
- 5: Kühlkörper
- 6: Kühlkörper
- 7: Kühlkanal
- 8: runder Querschnitt
- 9: Stirnseite
- 10: Kühlkanal quer
- 11: Bereich mit niedriger Temperatur
- 12: Bereich mit erhöhter Temperatur
- 13: ungekühlter Bereich
- 14: Kühlkörper
- 15: Kühlkanal
- 16: rechteckiger Querschnitt
- 17: Kühlflüssigkeit
- 18: Oberfläche des rechteckigen Querschnitts
- 19: Lamellen
- 20: oberer Kühlkörper
- 21: unterer Kühlkörper
- 22: Platine
- 23: Anschlusskammer
- 24: Widerstand
- 25: Steckbuchse bzw. Steckverbindung
- 26: Platinenkammer
- 27: Kühlmittelzulaufbohrung
- 28: Kühlmittelablaufbohrung
- 29: Schicht aus Sand bzw. Glimmer
- 30: Rücken
- 31: Seitenwand
- 32: Verbindungselement
- 33: Deckel
- 34: geradliniger Streckenabschnitt
- 35: Verbindungsstücke

## Patentansprüche

1. Elektrischer Widerstand mit einem, in einem Widerstandskörper (1) angeordneten Widerstandselement (22) und einer Kühleinrichtung, bei der Kühlflüssigkeit (17) wenigstens einen Kühlkanal (15) wenigstens zweier Kühlkörper (20; 21) durchströmt, die Kühlkanale (15) einen unrunden Querschnitt und einen flächendeckenden Verlauf durch die Kühlkörper (20; 21) aufweisen, **dadurch gekennzeichnet, dass** die wenigstens zwei Kühlkörper (20; 21) durch Anordnung wenigstens eines Zwischen-Kühlkörpers zwischen diesen modular übereinander oder nebeneinander angeordnet sind.

2. Elektrischer Widerstand nach Anspruch 1, **dadurch gekennzeichnet, dass** der wenigsten eine Kühlkanal (15) einen abgewinkelten Verlauf aufweist.

3. Elektrischer Widerstand nach Anspruch 1, **dadurch gekennzeichnet, dass** der wenigstens eine Kühlkanal (15) lamellenartige Rippen (19) aufweist, die in den Querschnitt des Kühlkanals (15) hineinragen.

4. Elektrischer Widerstand, nach einem oder mehreren der vorhergehenden Ansprüche, **dadurch gekennzeichnet, dass** der wenigstens eine Kühlkanal (15) einen wellenförmigen Boden aufweist.

5. Elektrischer Widerstand nach einem oder mehreren der vorhergehenden Ansprüche, **dadurch gekennzeichnet, dass** der wenigstens eine Kühlkanal (15) eine wellförmige Wandung aufweist.

6. Elektrischer Widerstand nach einem oder mehreren der vorhergehenden Ansprüche, **dadurch gekennzeichnet, dass** der wenigstens eine Kühlkanal (15) in ein Werkstück eingearbeitet ist und durch einen Deckel (33) abgedeckt ist.

7. Elektrischer Widerstand nach Anspruch 6, **dadurch gekennzeichnet, dass** der wenigstens eine Kühlkanal (15) in einen Alu-Guss-Körper (20; 21) eingearbeitet ist.

8. Elektrischer Widerstand nach einem der vorhergehenden Ansprüche, **dadurch gekennzeichnet, dass** der elektrische Widerstand ein Widerstandsgehäuse aufweist, das die miteinander verbundenen Kühlkörper umfasst, und das Widerstandsgehäuse zur Abführung von Kondenswasser eine Membran aufweist.

9. Elektrischer Widerstand nach einem oder mehreren der vorgehenden Ansprüche, **dadurch gekennzeichnet, dass** die wenigstens zwei Kühlkörper (20; 21) einen Werkstoff besonders hoher Wärmeleitfähigkeit aufweisen.

10. Elektrischer Widerstand nach einem oder mehreren der vorhergehenden Ansprüche, **dadurch gekennzeichnet, dass** die Kühlkanäle (15) in Reihe geschaltet sind.

11. Elektrischer Widerstand nach einem oder mehreren der Ansprüche 1 bis 9, **dadurch gekennzeichnet ist, dass** die Kühlkanäle (15) parallel geschaltet sind.

## Claims

1. Electrical resistor having a resistor element (22) arranged in a resistor body (1) and a cooling device in which cooling liquid (17) flows through at least one cooling channel (15) of at least two heat sinks (20; 21), wherein the cooling channels (15) have a non-circular cross section and a surface-covering course through the heat sinks (20; 21), **characterized in that** the at least two heat sinks (20; 21) are arranged modularly one above the other or adjacent to one another by arrangement of at least one intermediate heat sink between them.

2. Electrical resistor according to claim 1, **characterized in that** the at least one cooling channel (15) has an angled course.

3. Electrical resistor according to claim 1, **characterized in that** the at least one cooling channel (15) has lamellar ribs (19) which project into the cross section of the cooling channel (15).

4. Electrical resistor, according to one or more of the preceding claims, **characterized in that** the at least one cooling channel (15) has a wave-shaped bottom.

5. Electrical resistor, according to one or more of the preceding claims, **characterized in that** the at least one cooling channel (15) has a wave-shaped wall.

6. Electrical resistor, according to one or more of the preceding claims, **characterized in that** the at least one cooling channel (15) is incorporated into a workpiece and is covered by a cover (33).

7. Electrical resistor according to claim 6, **characterized in that** the at least one cooling channel (15) is incorporated into a cast aluminium body (20; 21).

8. Electrical resistor according to any of the preceding claims, **characterized in that** the electrical resistor has a resistor housing which encloses the heat sinks connected to each other and the resistor housing has a membrane for draining off condensation water.

9. Electrical resistor according to one or more of the preceding claims, **characterized in that** the at least two heat sinks (20; 21) comprise a material of especially high thermal conductivity.

10. Electrical resistor according to one or more of the preceding claims, **characterized in that** the cooling channels (15) are connected in series.

11. Electrical resistor according to one or more of claims 1 to 9, **characterized in that** the cooling channels (15) are connected in parallel.

## Revendications

1. Résistance électrique comportant un élément de résistance (22) agencé dans un corps de résistance (1) et un dispositif de refroidissement dans lequel le liquide de refroidissement (17) passe à travers au moins un canal de refroidissement (15) d'au moins deux corps de refroidissement (20 ; 21), les canaux de refroidissement (15) présentent une section transversale non circulaire et un parcours sur toute la surface à travers les corps de refroidissement (20 ; 21), **caractérisée en ce que** par la disposition d'au moins un corps de refroidissement intermédiaire, lesdits au moins deux corps de refroidissement (20 ; 21) sont agencés entre ceux-ci, de façon modulaire les uns au-dessus des autres ou les uns à côté des autres.

2. Résistance électrique selon la revendication 1, **caractérisée en ce que** ledit au moins un canal de refroidissement (15) présente un parcours coudé.

3. Résistance électrique selon la revendication 1, **caractérisée en ce que** ledit au moins un canal de refroidissement (15) présente des nervures (19) en forme de lamelles qui font saillie dans la section transversale du canal de refroidissement (15).

4. Résistance électrique selon l'une ou plusieurs des revendications précédentes, **caractérisée en ce que** ledit au moins un canal de refroidissement (15) présente un fond ondulé.

5. Résistance électrique selon l'une ou plusieurs des revendications précédentes, **caractérisée en ce que** ledit au moins un canal de refroidissement (15) présente une paroi ondulée.

6. Résistance électrique selon l'une ou plusieurs des revendications précédentes, **caractérisée en ce que** ledit au moins un canal de refroidissement (15) est intégré dans une pièce et recouvert par un couvercle (33).

7. Résistance électrique selon la revendication 6, **caractérisée en ce que** ledit au moins un canal de refroidissement (15) est intégré dans un corps en fonte d'aluminium (20 ; 21).

8. Résistance électrique selon l'une ou plusieurs des revendications précédentes, **caractérisée en ce que** la résistance électrique présente un boîtier de résistance qui comprend les corps de refroidissement reliés les uns aux autres, et le boîtier de résistance présente une membrane pour l'évacuation d'eau de condensation.

9. Résistance électrique selon l'une ou plusieurs des revendications précédentes, **caractérisée en ce que** lesdits au moins deux corps de refroidissement (20 ; 21) présentent un matériau possédant une conductibilité thermique particulièrement élevée.

10. Résistance électrique selon l'une ou plusieurs des revendications précédentes, **caractérisée en ce que** les canaux de refroidissement (15) sont montés en série.

11. Résistance électrique selon l'une ou plusieurs des revendications 1 à 9, **caractérisée en ce que** les canaux de refroidissement (15) sont montés en parallèle.
